# EUROPEAN PATENT APPLICATION

(11) **EP 1 803 833 A2**
(43) Date of publication of application: **04.07.2007**
(21) Application number: 06026153.4
(22) Date of filing: 18.12.2006
(51) Int. Cl.: C23C 14/54, C23C 14/58, C23C 28/04

(54) **Method of manufacturing ceramic film and ceramic film manufacturing apparatus**

(30) Priority: 27.12.2005 JP 2005374504
(71) Applicant: SEIKO EPSON CORPORATION, Shinjuku-ku Tokyo 163-0811 (JP)
(72) Inventor: Kijima, Takeshi c/o Seiko Epson Corporation, Nagano-ken 392-8502 (JP)
(74) Representative: Hoffmann, Eckart

(57) **Abstract**

A method of manufacturing a ceramic film including: forming a material layer above a base; introducing a gas including steam and oxygen gas into an oxidizing gas production section; and heating the gas in the oxidizing gas production section and supplying the heated gas to an oxidizing furnace to oxidize the material layer.

## Description

### BACKGROUND OF THE INVENTION

The present invention relates to a method of manufacturing a ceramic film and a ceramic film manufacturing apparatus.

In recent years, a ferroelectric memory (FeRAM) has been expected to be one of next-generation memories. An inkjet printer has been known as a printer enabling high-quality and high-speed printing. A ceramic film formed of a ferroelectric or a piezoelectric may be used for a ferroelectric memory, an inkjet printer head, and the like. A ceramic film formation process generally includes a heat treatment step performed at a high temperature (e.g. about 600° C to 850° C) (see JP-A-2001-223404, for example).

### SUMMARY

According to a first aspect of the invention, there is provided a method of manufacturing a ceramic film comprising:
forming a material layer above a base;
introducing a gas including steam and oxygen gas into an oxidizing gas production section; and
heating the gas in the oxidizing gas production section and supplying the heated gas to an oxidizing furnace to oxidize the material layer.

According to a second aspect of the invention, there is provided a ceramic film manufacturing apparatus comprising:
an oxidizing furnace;
a base mounting section provided in the oxidizing furnace; and
an oxidizing gas production section provided above the base mounting section, the oxidizing gas production section including:
   a supply section which supplies a gas to the base mounting section;
   a plurality of gas chambers provided above the supply section and apart from one another;
   a plurality of communicating tubes which connect the gas chambers; and
   a heating section which heats the gas chambers and the communicating tubes.

### BRIEF DESCRIPTION OF THE SEVERAL VIEWS OF THE DRAWING

FIG. 1 is a cross-sectional view schematically showing a manufacturing step of a capacitor according to one embodiment of the invention.

FIG. 2 is a schematic view showing a ceramic film manufacturing apparatus according to one embodiment of the invention.

FIG 3 is a cross-sectional view schematically showing a manufacturing step of a capacitor according to one embodiment of the invention.

FIG. 4 is a perspective view schematically showing main components of a ceramic film manufacturing apparatus.

FIG. 5 is a perspective view schematically showing a modification of main components of a ceramic film manufacturing apparatus.

FIG. 6 shows results of X-ray diffraction measurement when conducting an experiment at a base temperature of about 300° C.

FIG. 7 shows results of X-ray diffraction measurement when conducting an experiment at a base temperature of about 300° C.

FIG. 8 shows results of X-ray diffraction measurement when conducting an experiment at a base temperature of about 200° C.

FIG. 9 is a cross-sectional view schematically showing a manufacturing step of a capacitor according to one embodiment of the invention.

FIG. 10 shows H-NMR analysis results of water obtained through an oxidizing gas production section.

FIG 11 shows H-NMR analysis results of purified water.

### DETAILED DESCRIPTION OF THE EMBODIMENT

The invention may provide a method of manufacturing a ceramic film capable of forming a ceramic film at a low temperature, and a ceramic film manufacturing apparatus.

According to one embodiment of the invention, there is provided a method of manufacturing a ceramic film comprising:
forming a material layer above a base;
introducing a gas including steam and oxygen gas into an oxidizing gas production section; and
heating the gas in the oxidizing gas production section and supplying the heated gas to an oxidizing furnace to oxidize the material layer.

According to this method of manufacturing a ceramic film, a ceramic film can be formed at a low temperature in comparison with a known method of manufacturing a ceramic film. The details are described later.

In this method of manufacturing a ceramic film,

the step of forming the material layer may include:
applying a solution including a raw material solution of the ceramic film to the base or a layer disposed above the base; and
subjecting the applied solution to heat treatment.

In this method of manufacturing a ceramic film,

the oxidizing gas production section may include:
a first gas chamber;
a plurality of communicating tubes connected to the first gas chamber;
a second gas chamber connected to the communicating tubes; and
a supply section which is connected to the second gas chamber and supplies the gas to the oxidizing furnace.

In this method of manufacturing a ceramic film,
the step of supplying the gas in the oxidizing gas production section to the oxidizing furnace may include:
a first step of supplying the gas to the first gas chamber; and
a second step of supplying the gas to the second gas chamber through the communicating tubes.

In this method of manufacturing a ceramic film,
the step of supplying the gas to the oxidizing furnace may include:
a first step of supplying the gas to a first gas chamber disposed on an upper stage; and
a second step of supplying the gas to a second gas chamber disposed on a lower stage through a plurality of communicating tubes connected to the first gas chamber,
wherein a series of steps including the first step and the second step may be performed from the gas chamber in an uppermost stage to the gas chamber in a lowermost stage.

In this method of manufacturing a ceramic film, a temperature of the base when oxidizing the material layer may be at least 200° C and equal to or less than 500° C.

In this method of manufacturing a ceramic film, a temperature of the base when oxidizing the material layer may be at least 200° C and equal to or less than 300° C.

In this method of manufacturing a ceramic film, water molecules in the gas supplied to the oxidizing furnace may be in an unclustered state.

In the invention, the term "unclustered state" means that all or many of water molecules are not in a clustered state but are dispersed (separated).

According to one embodiment of the invention, there is provided a ceramic film manufacturing apparatus comprising:
an oxidizing furnace;
a base mounting section provided in the oxidizing furnace; and
an oxidizing gas production section provided above the base mounting section, the oxidizing gas production section including:
   a supply section which supplies a gas to the base mounting section;
   a plurality of gas chambers provided above the supply section and apart from one another;
   a plurality of communicating tubes which connect the gas chambers; and
   a heating section which heats the gas chambers and the communicating tubes.

In this ceramic film manufacturing apparatus, positions of two of the communicating tubes respectively disposed above and under each of the gas chambers may not coincide with each other when viewed from above.

Embodiments of the invention are described below with reference to the drawings.

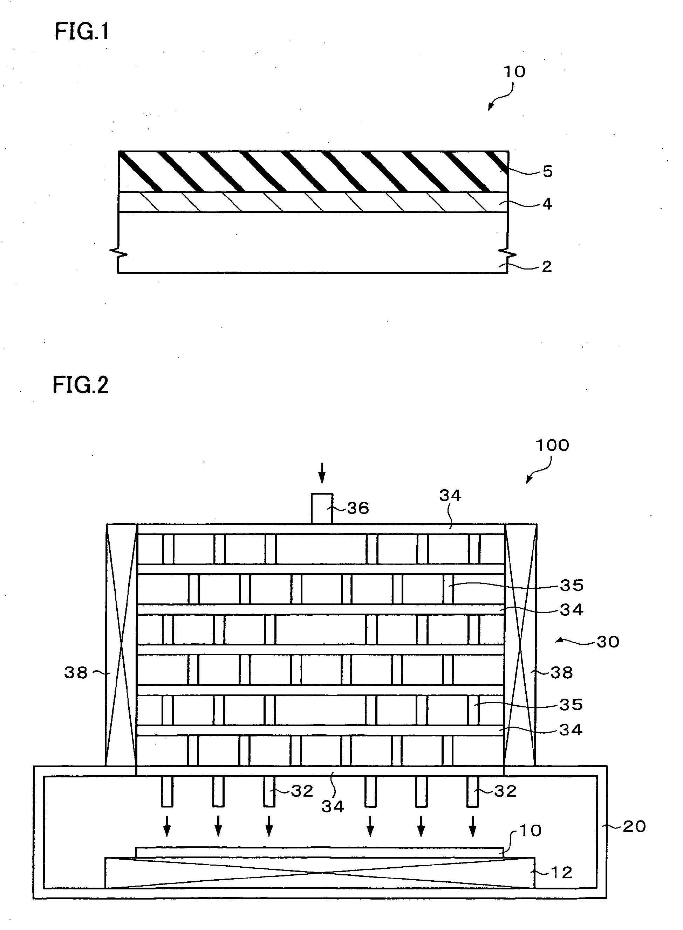

A method of manufacturing a capacitor to which a ceramic film according to this embodiment is applied is described below together with a ceramic film manufacturing apparatus according to this embodiment. FIGS. 1 to 3 and FIG 9 are cross-sectional views schematically showing manufacturing steps of a capacitor 1 to which a ceramic film 6 according to this embodiment is applied. FIG 2 also provides a schematic view showing a ceramic film manufacturing apparatus 100 used in the method of manufacturing a capacitor according to this embodiment.

A lower electrode 4 is formed on a base 2. The base 2 is not particularly limited. For example, a semiconductor substrate, a resin substrate, or a product in which an insulating layer or the like is stacked on such a substrate may be used as the base 2. The lower electrode 4 is not particularly limited. For example, platinum (Pt) or a film in which a conductive oxide having a perovskite structure (e.g. LaNiO₃ or SrRuO₃) is stacked on platinum may be used as the lower electrode 4. The lower electrode 4 may be formed by sputtering, spin coating, CVD, laser ablation, or the like.

As shown in FIG 1, a material layer 5 for forming the ceramic film 6 is stacked on the lower electrode 4. For example, a solution prepared by mixing a plurality of raw material solutions at such a ratio that the resulting ceramic film 6 has a desired composition ratio is applied to the lower electrode 4 (mixed solution application step). The raw material solution may be prepared by mixing organometals including constituent metals of the material for the ceramic film 6 so that the respective metals are contained at a desired molar ratio, and dissolving or dispersing the mixture in an organic solvent such as an alcohol (e.g. n-butanol). When using lead zirconate titanate niobate (Pb(Zr,Ti,Nb)O₃) (hereinafter also called "PZTN") as the ceramic film 6, Pb, Zr, Ti, and Nb are constituent metals of the material for the ceramic film 6. As the organometal, a metal alkoxide, an organic acid salt, or the like may be used. Note that the ceramic film 6 is not limited to PZTN. For example, various oxides such as lead zirconate titanate (Pb(Zr,Ti)O₃: PZT) may also be used.

Various additives such as a stabilizer may optionally be added to the raw material solution. When causing the raw material solution to undergo hydrolysis and polycondensation, an acid or a base may be added to the raw material solution as a catalyst together with an appropriate amount of water.

The mixed solution is then subjected to heat treatment in air using a hot plate or the like at a temperature (e.g. 150° C) higher than the boiling point of the solvent used for the raw material solution by about 10° C, for example (drying heat treatment step).

The mixed solution is then subjected to heat treatment in air using a hot plate or the like at about 300° C to 350° C in order to decompose and remove a ligand of the organometal used for the raw material solution, for example (cleaning heat treatment step).

A series of steps including the mixed solution application step, the drying heat treatment step, and the cleaning heat treatment step may be repeatedly performed an appropriate number of times depending on the desired film thickness.

A laminate 10, in which the lower electrode 4 and the material layer 5 are formed on the base 2, is obtained by the above-described steps.

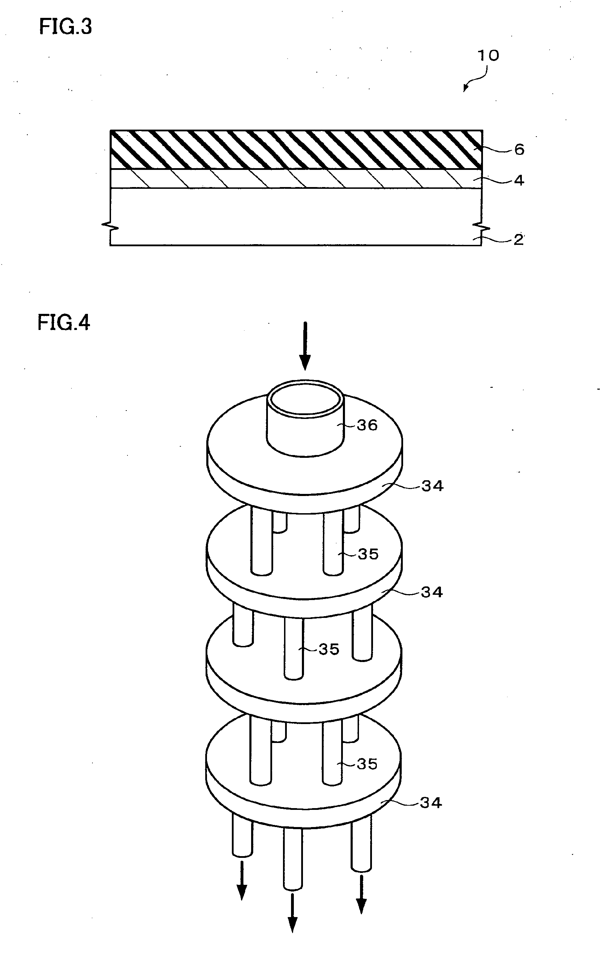

As shown in FIGS. 2 and 3, the ceramic film 6 is formed using the ceramic film manufacturing apparatus 100 according to this embodiment. The ceramic film manufacturing apparatus 100 according to this embodiment is described below.

The ceramic film manufacturing apparatus 100 according to this embodiment includes an oxidizing furnace 20, a base mounting section 12, and an oxidizing gas production section 30.

The base mounting section 12 is provided in the oxidizing furnace 20. The base 2 (laminate 10) on which the lower electrode 4 and the material layer 5 are stacked by the above-described steps can be mounted on the base mounting section 12. The base mounting section 12 may include a heater. The laminate 10 may be heated using the heater.

The oxidizing gas production section 30 is provided over the base mounting section 12. The oxidizing gas production section 30 includes a supply section 32, a plurality of gas chambers 34, a plurality of communicating tubes 35, an inlet section 36, and a heating section 38. An active oxidizing gas is jetted (supplied) from the supply section 32 toward the base mounting section 12. The active oxidizing gas may include an active oxygen gas, for example. The supply section 32 may be a long and narrow columnar tube, for example. In the example shown in FIG. 2, the supply section 32 is tubular. Note that an opening may be formed in the bottom surface of the lowermost gas chamber 34, and the opening may be utilized as the supply section 32.

As shown in FIG. 2, the gas chambers 34 are disposed at intervals over the supply section 32. In the example shown in FIG 2, the gas chambers 34 are formed in seven stages. Note that the number of stages is not limited to seven, and may be arbitrarily increased or decreased. The communicating tubes 35 connect the gas chambers 34. The number of communicating tubes 35 disposed in each stage is not particularly limited, and may be arbitrarily increased or decreased. As shown in FIG 4, the communicating tubes 35 adjacent to the gas chamber 34 at the top and bottom thereof may not overlap in plan view. The communicating tubes 35 adjacent to the gas chamber 34 at the top and bottom thereof may be displaced in plan view. In the example shown in FIG 4, the communicating tubes 35 are displaced by 45° around the center of the gas chamber 34 in plan view. FIG. 4 is a perspective view schematically showing the main portion of the ceramic film manufacturing apparatus 100, in which the number of members, size, and the like are simplified for convenience. The gas chamber 34 may be a flat columnar tube as shown in FIG 4, for example. The communicating tube 35 may be a long and narrow columnar tube as shown in FIG 4, for example. The diameter of the gas chamber 34 in plan view is greater than the diameter of the communicating tube 35 in plan view, as shown in FIG 4. The shape, size, and the like of the gas chamber 34 and the communicating tube 35 are not limited to those of the example shown in FIG 4, and may be arbitrarily changed.

A raw material gas containing steam and oxygen gas is introduced into the inlet section 36. The inlet section 36 may be a columnar tube as shown in FIG. 4, for example. The heating section 38 can heat the gas chambers 34 and the communicating tubes 35.

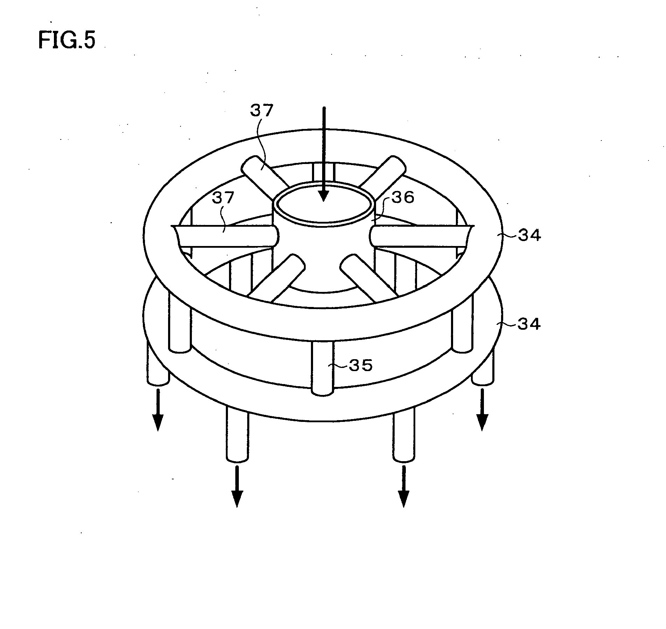

The gas chambers 34 and the communicating tubes 35 may be shaped and disposed as shown in FIG 5, for example. FIG 5 is a perspective view schematically showing a modification of the main portion of the ceramic film manufacturing apparatus 100, in which the number of members, size, and the like are simplified for convenience. The gas chamber 34 may be a circular tube as shown in FIG. 5, for example. The outer diameter of the gas chamber 34 in plan view is greater than the diameter of the communicating tube 35 in plan view, as shown in FIG 5. In the example shown in the drawing, the communicating tubes 35 adjacent to the gas chamber 34 at the top and bottom thereof are displaced by 45° around the center of the gas chamber 34 in plan view. The gas chamber 34 in the uppermost stage is connected with the inlet section 36 through a plurality of (six in the example shown in FIG 5) connecting tubes 37. The inlet section 36 may be a columnar tube closed at the bottom as shown in FIG. 5, for example. The connecting tubes 37 are radially disposed around the inlet section 36 in plan view. Note that this modification is only an example, and the invention is not limited thereto.

The ceramic film 6 is formed using the above-described ceramic film manufacturing apparatus 100. As shown in FIG 2, the base 2 (laminate 10) on which the lower electrode 4 and the material layer 5 are stacked is placed on the base mounting section 12. A raw material gas containing steam (H₂O) and oxygen gas (O₂) is introduced into the oxidizing gas production section 30. The raw material gas is initially introduced into the inlet section 36. The gas inside the inlet section 36 is supplied to the gas chamber 34 disposed in the uppermost stage. The gas jetted from the inlet section 36 collides with the bottom surface of the gas chamber 34 and is diffused. The gas is then supplied to the gas chamber 34 disposed in the next stage through the communicating tubes 35 connected with the gas chamber 34 in the uppermost stage. The gas jetted from the communicating tubes 35 collides with the bottom surface of the gas chamber 34 and is diffused. The gas introduced into the inlet section 36 can flow from the gas chamber 34 in the uppermost stage to the gas chamber 34 in the lowermost stage while repeatedly colliding with the bottom surface of the gas chamber 34 in this manner.

Specifically, the gas is supplied to the gas chamber (first gas chamber) 34 disposed in the uppermost stage (first step). The gas is then supplied to the gas chamber (second gas chamber) 34 disposed in the next stage through the communicating tubes 35 connected with the first gas chamber 34 (second step). The gas can flow while repeatedly colliding with the bottom surface of the gas chamber 34 by performing a series of steps including the first step and the second step from the gas chamber 34 in the uppermost stage to the gas chamber 34 in the lowermost stage.

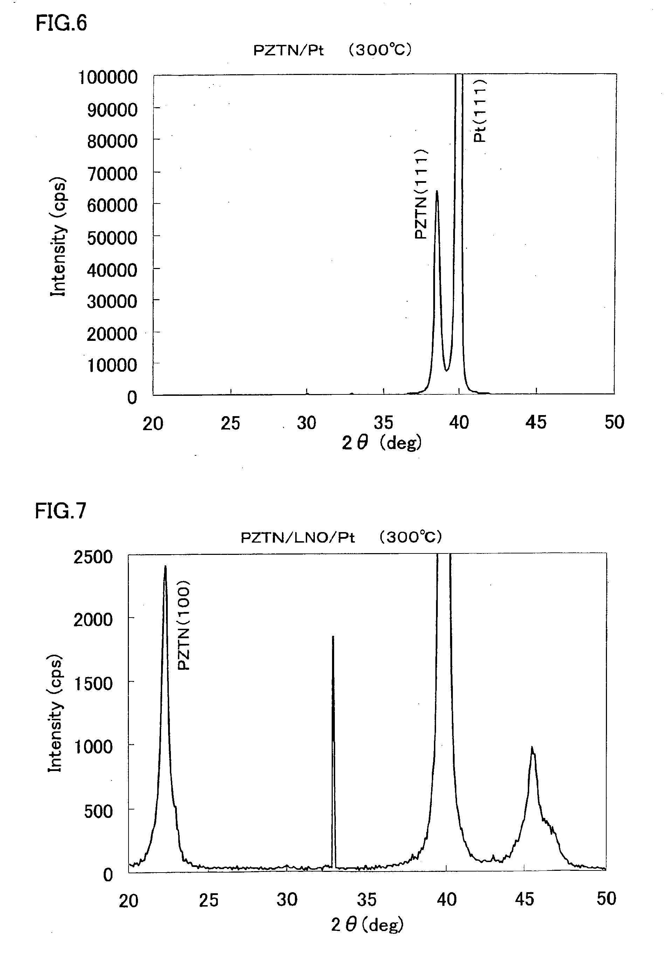

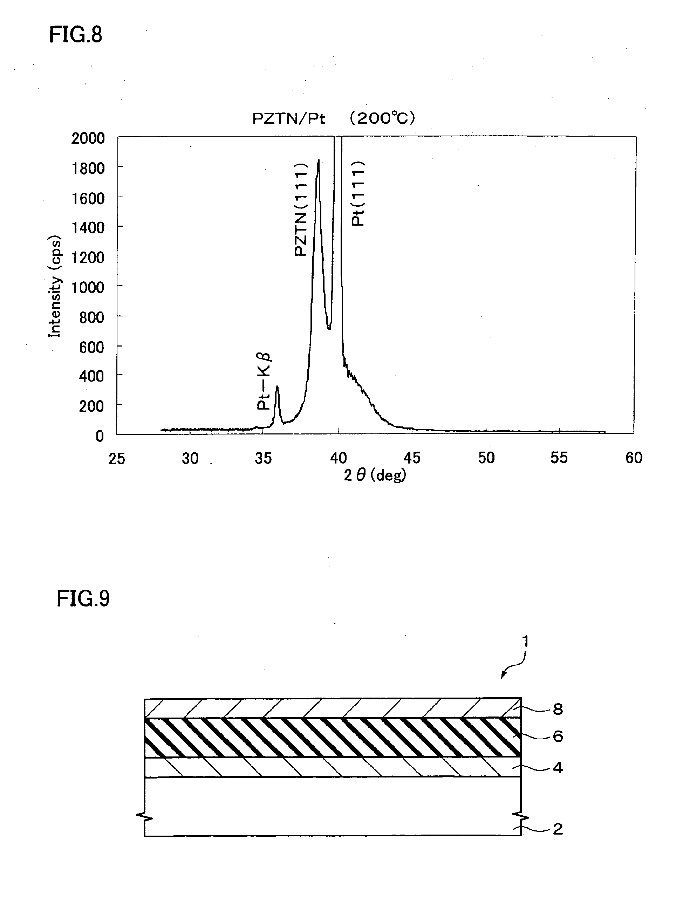

The gas chambers 34 and the communicating tubes 35 are heated using the heating section 38 so that the gas flowing therethrough is also heated. The gas which has flowed from the gas chamber 34 in the uppermost stage to the gas chamber 34 in the lowermost stage gas is jetted (supplied) from the supply section 32 into the oxidizing furnace 20 as an active oxidizing gas. In the oxidizing furnace 20, the laminate 10 is heated by the base mounting section 12. The material layer 5 can be thus subjected to heat treatment in an active oxidizing gas atmosphere. This causes the material layer 5 to be oxidized and crystallized, whereby the ceramic film 6 is formed, as shown in FIG 3. The temperature of the base 2 in this heat treatment step may be set at 200° C or more and 500° C or less or 200° C or more and 300° C or less, for example. FIGS. 6 and 7 show results of X-ray diffraction measurement when conducting an experiment while setting the temperature of the base 2 at about 300° C. FIG 6 shows the case of using (111)-oriented platinum (Pt) as the lower electrode 4 and PZTN as the ceramic film 6. FIG 7 shows the case of using a film formed by stacking (100)-oriented LaNiO₃ on platinum as the lower electrode 4 and PZTN as the ceramic film 6. FIGS. 6 and 7 show the cases of using steam and oxygen gas as the raw material gas. As shown in FIGS. 6 and 7, it was confirmed that a ceramic film 6 crystallized with excellent orientation can be obtained when the temperature of the base 2 in the heat treatment step is about 300° C. FIG 8 shows results of X-ray diffraction measurement when conducting an experiment while setting the temperature of the base 2 at about 200° C. FIG 8 shows the case of using (111)-oriented platinum (Pt) as the lower electrode 4, PZTN as the ceramic film 6, and steam and oxygen gas as the raw material gas. As shown in FIG 8, it was confirmed that a ceramic film 6 crystallized with excellent orientation can also be obtained when the temperature of the base 2 in the heat treatment step is about 200° C.

As shown in FIG 9, an upper electrode 8 is formed on the ceramic film 6. The upper electrode 8 is not particularly limited. For example, platinum (Pt) or a film in which platinum is stacked on a conductive oxide having a perovskite structure (e.g. LaNiO₃ or SrRuO₃) may be used as the upper electrode 8. The upper electrode 8 may be formed by sputtering, spin coating, chemical vapor deposition (CVD), laser ablation, or the like.

The capacitor 1 according to this embodiment can be manufactured by the above-described steps.

According to this embodiment, the ceramic film 6 can be formed at a low temperature (i.e. the temperature of the base 2 is 200° C or more and 500° C or less or 200° C or more and 300° C or less) in comparison with a known ceramic film manufacturing method, as described above. The reasons therefor are estimated as follows.

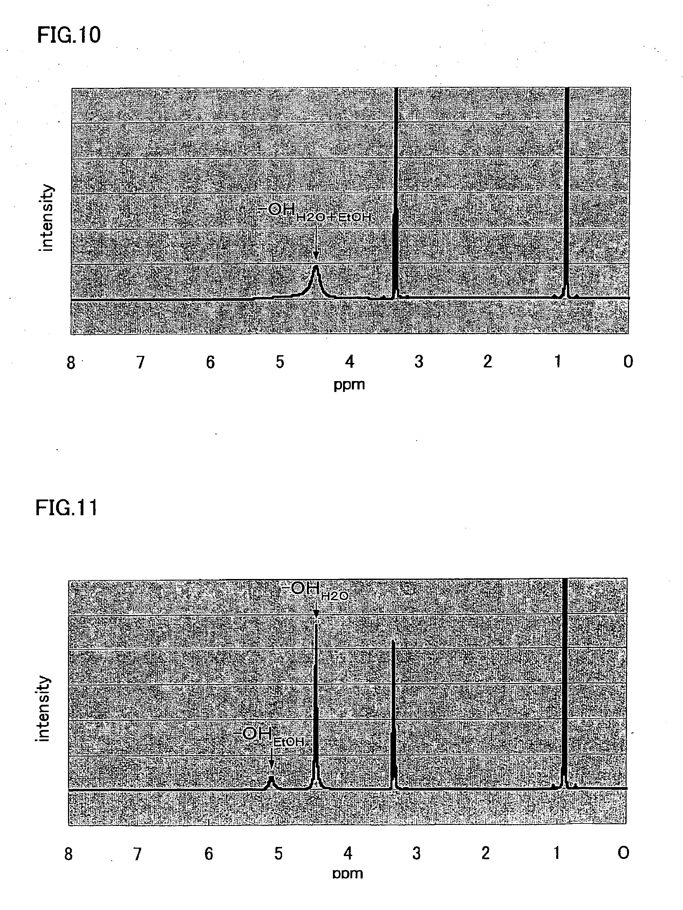

FIG. 10 shows H-NMR analysis results of a product obtained by causing steam to flow through the oxidizing gas production section 30, collecting the jetted steam to obtain water, and adding ethanol to the water. FIG. 11 shows H-NMR analysis results of a product obtained by adding ethanol to normal purified water. Water and ethanol were mixed at a molar ratio of 2:1. As shown in FIGS. 10 and 11, water obtained through the oxidizing gas production section 30 shows a peak indicating a hydrogen bond (peak of hydroxyl group (-OH)) smaller than that of normal purified water. This indicates that water molecules in water obtained through the oxidizing gas production section 30 are in an unclustered state (i.e. all or many of the water molecules are not in a clustered state but are dispersed). According to this embodiment, since the water molecules in an unclustered state activate oxygen gas so that an active oxidizing gas with a strong oxidizing capability can be supplied to the oxidizing furnace 20, the ceramic film 6 can be formed at a low temperature.

Although only some embodiments of the invention have been described in detail above, those skilled in the art will readily appreciate that many modifications are possible in the embodiments without materially departing from the novel teachings and advantages of this invention. Accordingly, all such modifications are intended to be included within the scope of the invention.

## Claims

1. A method of manufacturing a ceramic film comprising:
forming a material layer above a base;
introducing a gas including steam and oxygen gas into an oxidizing gas production section; and
heating the gas in the oxidizing gas production section and supplying the heated gas to an oxidizing furnace to oxidize the material layer.

2. The method of manufacturing a ceramic film as defined in claim 1,
wherein the step of forming the material layer includes:
applying a solution including a raw material solution of the ceramic film to the base or a layer disposed above the base; and
subjecting the applied solution to heat treatment.

3. The method of manufacturing a ceramic film as defined in claim 1 or 2,
wherein the oxidizing gas production section includes:
a first gas chamber;
a plurality of communicating tubes connected to the first gas chamber;
a second gas chamber connected to the communicating tubes; and
a supply section which is connected to the second gas chamber and supplies the gas to the oxidizing furnace.

4. The method of manufacturing a ceramic film as defined in claim 3,
wherein the step of supplying the gas in the oxidizing gas production section to the oxidizing furnace includes:
a first step of supplying the gas to the first gas chamber; and
a second step of supplying the gas to the second gas chamber through the communicating tubes.

5. The method of manufacturing a ceramic film as defined in any one of claims 1 to 4,
wherein a temperature of the base when oxidizing the material layer is at least 200° C and equal to or less than 500° C.

6. The method of manufacturing a ceramic film as defined in any one of claims 1 to 4,
wherein a temperature of the base when oxidizing the material layer is at least 200° C and equal to or less than 300° C.

7. The method of manufacturing a ceramic film as defined in any one of claims 1 to 6,
wherein water molecules in the gas supplied to the oxidizing furnace are in an unclustered state.

8. A ceramic film manufacturing apparatus comprising:
an oxidizing furnace;
a base mounting section provided in the oxidizing furnace; and
an oxidizing gas production section provided above the base mounting section, the oxidizing gas production section including:
a supply section which supplies a gas to the base mounting section;
a plurality of gas chambers provided above the supply section and apart from one another;
a plurality of communicating tubes which connect the gas chambers; and
a heating section which heats the gas chambers and the communicating tubes.

9. The ceramic film manufacturing apparatus as defined in claim 8,
wherein positions of two of the communicating tubes respectively disposed above and under each of the gas chambers do not coincide with each other when viewed from above.
